# EUROPEAN PATENT SPECIFICATION

(11) **EP 2 055 013 B1**
(45) Date of publication and mention of the grant of the patent: **29.06.2016**
(21) Application number: 07837283.6
(22) Date of filing: 24.08.2007
(51) Int. Cl.: H03F 3/195, H03F 3/24, H03F 1/32, H04B 1/04

(54) **ADAPTIVE PREDISTORTION FOR CONTROLLING AN OPEN LOOP POWER AMPLIFIER**
ADAPTIVE VORVERZERRUNG ZUR STEUERUNG EINES OPEN-LOOP-LEISTUNGSVERSTÄRKERS
PRÉDISTORSION ADAPTATIVE UTILISÉE POUR COMMANDER UN AMPLIFICATEUR DE PUISSANCE EN BOUCLE OUVERTE

(30) Priority: 25.08.2006 US 510465
(43) Date of publication of application: 06.05.2009
(73) Proprietor: Skyworks Solutions, Inc., Woburn, MA 01801 (US)
(72) Inventor: KOMAILI, Jaleh, Irvine, CA 92603-3410 (US); VASA, John, E., Irvine, CA 92606 (US); DAMGAARD, Morten, Laguna Hills, CA 92653 (US); RIPLEY, David, S., Cedar Rapids, IA 52402-6911 (US)
(74) Representative: Lloyd, Patrick Alexander Desmond
(86) International application number: PCT/US2007/018693
(87) International publication number: WO 2008/027295

(56) References cited:
- US-A1- 2005 156 662
- US-A1- 2005 156 662

## Description

### BACKGROUND OF THE INVENTION

Radio frequency (RF) transmitters are found in many one-way and two-way communication devices, such as portable communication devices, (cellular telephones), personal digital assistants (PDAs) and other communication devices. An RF transmitter must transmit using whatever communication methodology is dictated by the particular communication system within which it is operating. For example, communication methodologies typically include amplitude modulation, frequency modulation, phase modulation, or a combination of these. In a typical GSM mobile communication system using narrowband TDMA technology, a GMSK/8-PSK modulation scheme supplies a low noise phase modulated (PM) transmit signal to a non-linear power amplifier directly from an oscillator.

Typically, the power output of a power amplifier is controlled using either closed-loop methodology or an open-loop methodology. In a closed-loop power control system, a portion of the output of the power amplifier is diverted to closed-loop power control circuitry associated with the power amplifier. The closed-loop power control circuitry analyzes a number of factors, including a power control signal generated in the device and the power output of the power amplifier, and determines the optimal desired power to be output from the power amplifier. The closed-loop power control circuitry then delivers a power control signal to the power amplifier to control the power amplifier power output. Unfortunately, a closed-loop power control system requires costly components and consumes valuable space on the device in which the transmitter is fabricated.

Open power control systems have been implemented in an effort to reduce the cost associated with a closed-loop power control system. In an open loop power control system, power amplifier non-linearities are estimated during manufacturing and the inverse of those estimates are applied to the power amplifier as pre-distortion during normal operating conditions. The pre-distortion settings are developed from compensation curves that are generated as a result of the factory-estimated non-linearities. As long as the power amplifier characteristics remain stable, such an approach provides acceptable results. However, while some power amplifier subsystems may remain stable over time, temperature variations, aging, etc., there are other operating conditions that can alter the response of the power amplifier. For example, a change in the voltage standing wave ratio (VSWR) at the power amplifier output can alter the operating parameters (and response) of the power amplifier for a period of time sufficient to cause transmission failures. This occurs when the power amplifier encounters an operating condition for which the compensation curves that are generated as a result of the factory-estimated non-linearities no longer apply. Open loop power control systems are vulnerable to such conditions.

Therefore, it would be desirable to overcome such operating limitations.

US 2005/0156662 discloses amplifier AM and PM predistortion and auto calibration. The amplifier is characterised by measuring the performance and generating characterisation curves. Alternatively, the characteristics may be supplied by a manufacturer.

### SUMMARY

The invention is defined by the independent claims to which reference should be made.

Embodiments of the invention include an adaptive predistortion system for controlling an open loop power amplifier including a transmitter, a receiver, a phase and amplitude determination element configured to determine amplitude and phase characteristics of an output signal generated in the transmitter, the signal representing transmitter characteristics, an amplitude resampling element configured to generate an updated AM-AM predistortion signal based on the output signal generated in the transmitter, and an amplitude predistortion element configured to compare the updated AM-AM predistortion signal with a factory-calibrated AM-AM predistortion signal and generate an amplitude compensation signal. The adaptive predistortion system also includes a phase comparison element configured to compare the signal representing transmitter characteristics with a desired phase signal, a phase resampling element configured to generate an updated AM-PM predistortion signal based on the output signal generated in the transmitter, and a phase predistortion element configured to compare the updated AM-PM predistortion signal with a factory-calibrated AM-PM predistortion signal and generate a phase compensation signal.

Related methods of operation are also provided. Other systems, methods, features, and advantages of the invention will be or become apparent to one with skill in the art upon examination of the following figures and detailed description. It is intended that all such additional systems, methods, features, and advantages be included within this description, be within the scope of the invention, and be protected by the accompanying claims.

### BRIEF DESCRIPTION OF THE FIGURES

The invention can be better understood with reference to the following figures. The components within the figures are not necessarily to scale, emphasis instead being placed upon clearly illustrating the principles of the invention. Moreover, in the figures, like reference numerals designate corresponding parts throughout the different views.
FIG. 1 is a block diagram illustrating a simplified portable transceiver.
FIG. 2 is a block diagram illustrating an open-loop polar RF transmitter and a portion of a receiver in accordance with an embodiment of the invention.
FIG. 3 is a graphical illustration showing an 8-PSK time mask and power signal showing the time period during which embodiments of the invention are implemented.
FIG. 4 is a graphical illustration showing an example of AM-AM power amplifier distortion curves showing a factory calibration curve and an estimated curve.
FIG. 5 is a graphical illustration showing an example of AM-PM power amplifier distortion curves showing a factory calibration curve and an estimated curve.
FIG. 6 is a flowchart showing the operation of an embodiment of the adaptive predistortion system and method.

### DETAILED DESCRIPTION

Although described with particular reference to a portable transceiver, the adaptive predistortion system and method for controlling an open loop power amplifier can be implemented in any system in which a transmitted signal includes both an AM component and a PM component, and in which the AM component is applied to the control port of the power amplifier.

The adaptive predistortion system and method for controlling an open loop power amplifier can be implemented in hardware, software, or a combination of hardware and software. When implemented in hardware, the adaptive predistortion system and method for controlling an open loop power amplifier can be implemented using specialized hardware elements and logic. When the adaptive predistortion system and method for controlling an open loop power amplifier is implemented partially in software, the software portion can be used to adaptively apply estimated AM and PM pre-distortion characteristics to the transmitter, thereby compensating for the AM and PM characteristics during normal use of the transmitter, if these characteristics should change as a function of temperature, aging, VSWR or other factors. The software can be stored in a memory and executed by a suitable instruction execution system (microprocessor). The hardware implementation of the adaptive predistortion system and method for controlling an open loop power amplifier can include any or a combination of the following technologies, which are all well known in the art: discrete electronic components, a discrete logic circuit(s) having logic gates for implementing logic functions upon data signals, an application specific integrated circuit having appropriate logic gates, a programmable gate array(s) (PGA), a field programmable gate array (FPGA), *etc.*

The software for the adaptive predistortion system and method for controlling an open loop power amplifier comprises an ordered listing of executable instructions for implementing logical functions, and can be embodied in any computer-readable medium for use by or in connection with an instruction execution system, apparatus, or device, such as a computer-based system, processor-containing system, or other system that can fetch the instructions from the instruction execution system, apparatus, or device and execute the instructions.

In the context of this document, a "computer-readable medium" can be any means that can contain, store, communicate, propagate, or transport the program for use by or in connection with the instruction execution system, apparatus, or device. The computer readable medium can be, for example but not limited to, an electronic, magnetic, optical, electromagnetic, infrared, or semiconductor system, apparatus, device, or propagation medium. More specific examples (a non-exhaustive list) of the computer-readable medium would include the following: an electrical connection (electronic) having one or more wires, a portable computer diskette (magnetic), a random access memory (RAM), a read-only memory (ROM), an erasable programmable read-only memory (EPROM or Flash memory) (magnetic), an optical fiber (optical), and a portable compact disc read-only memory (CDROM) (optical). Note that the computer-readable medium could even be paper or another suitable medium upon which the program is printed, as the program can be electronically captured, via for instance, optical scanning of the paper or other medium, then compiled, interpreted or otherwise processed in a suitable manner if necessary, and then stored in a computer memory.

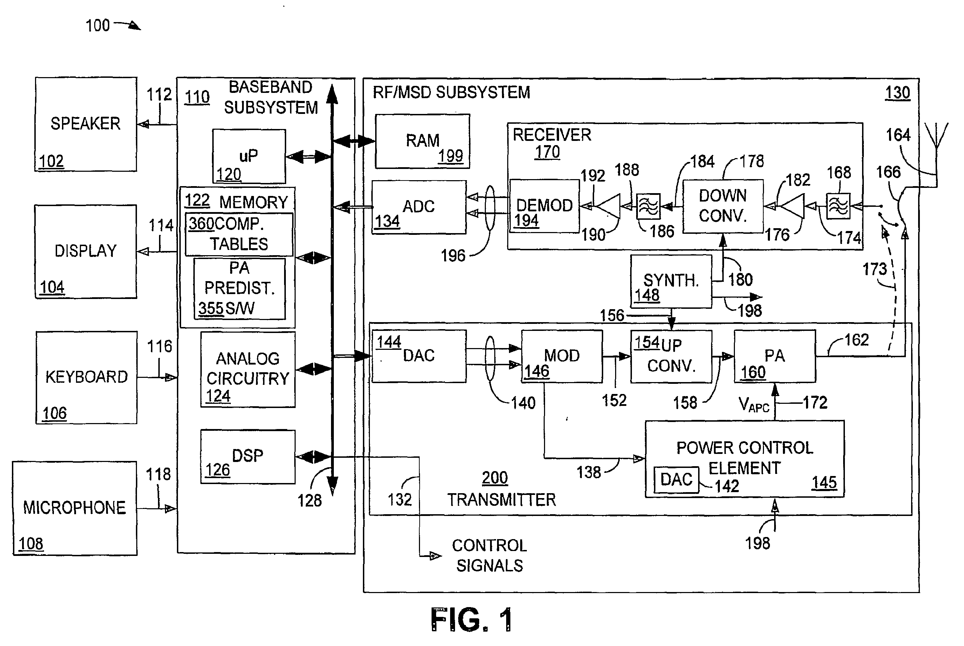

FIG. 1 is a block diagram illustrating a simplified portable transceiver 100. The portable transceiver 100 includes speaker 102, display 104, keyboard 106, and microphone 108, all connected to baseband subsystem 110. In a particular embodiment, the portable transceiver 100 can be, for example but not limited to, a portable telecommunication handset such as a mobile cellular-type telephone. The speaker 102 and the display 104 receive signals from the baseband subsystem 110 via connections 112 and 114, respectively, as known to those skilled in the art. Similarly, the keyboard 106 and the microphone 108 supply signals to the baseband subsystem 110 via connections 116 and 118, respectively. The baseband subsystem 110 includes microprocessor (µP) 120, memory 122, analog circuitry 124, and digital signal processor (DSP) 126 in communication via bus 128. The bus 128, though shown as a single bus, may be implemented using a number of busses connected as appropriate among the subsystems within baseband subsystem 110. The microprocessor 120 and the memory 122 provide the signal timing, processing and storage functions for the portable transceiver 100. If portions of the adaptive predistortion system and method for controlling an open loop power amplifier are implemented in software, then the memory 122 also includes power amplifier pre-distortion software 355 that can be executed by the microprocessor 120, the DSP 126 or by another processor, and compensation tables 360 that are developed based on the performance of the transmitter 200 and used to compensate for non-linearities in the power amplifier, to be described below.

The analog circuitry 124 provides the analog processing functions for the signals within the baseband subsystem 110. The baseband subsystem 110 communicates with the radio frequency (RF)/mixed signal device (MSD) subsystem 130 via the bus 128.

The RF/MSD subsystem 130 includes both analog and digital components. For example, the RF/MSD subsystem 130 includes a transmitter 200, a receiver 170, an analog-to-digital converter 134, and one or more analog-to-digital converters (DAC). In this embodiment, the transmitter 200 includes a DAC 144. The DAC 144 processes the digital transmit data to be supplied to the modulator 146.

In one embodiment, the baseband subsystem 110 provides control signals via connection 132 that may originate from the DSP 126 from microprocessor 120, or from another element, and are supplied to a variety of points within the RF/MSD subsystem 130. It should be noted that, for simplicity, only the basic components of portable transceiver 100 are illustrated.

The ADC 134 and the DAC 144 also communicate with microprocessor 120, memory 122, analog circuitry 124 and DSP 126 via bus 128. The DAC 144 converts the digital communication information within baseband subsystem 110 into an analog signal for transmission by the transmitter 200 via connection 140. Connection 140, while shown as two directed arrows, includes the information that is to be transmitted by RF/MSD subsystem 130 after conversion from the digital domain to the analog domain.

The DAC 144 may operate on either baseband in-phase (I) and quadrature-phase (Q) components or phase and amplitude components of the information signal. In the case of I and Q signals, the modulator 146 is an I/Q modulator as known in the art while in the case of phase and amplitude components, the modulator 146 operates as a phase modulator utilizing only the phase component and passes the amplitude component, unchanged, to the power control element 145.

The modulator 146 modulates, either the I and Q information signals or the phase information signal received from the DAC 144 onto an LO signal and provides a modulated signal via connection 152 to upconverter 154. It will be understood by those skilled in the art that in other embodiments the operations performed by the modulator 146 and upconverter 154 can be performed by a single block.

The upconverter 154 receives a frequency reference signal (referred to as a "local oscillator" or "LO" signal) from synthesizer 148 via connection 156. The synthesizer 148 determines the appropriate frequency to which the upconverter 154 will translate the modulated signal on connection 152.

The upconverter 154 supplies the modulated signal at the appropriate transmit frequency via connection 158 to power amplifier 160. The power amplifier 160 amplifies the modulated signal on connection 158 to the appropriate power level for transmission via connection 162 to antenna 164. Illustratively, switch 166 is a three-way switch that controls whether the amplified signal on connection 162 is transferred to antenna 164, directly from the transmitter output to the receiver input or whether a received signal from antenna 164 is supplied to filter 168 in the receiver 170. In one embodiment, the switch 166 is positioned so that the output of the transmitter 200 is supplied directly to the receiver 170 so that the transmitter characteristics, and in particular, the AM-AM and AM-PM characteristics can be analyzed and simultaneously compensated during either a power ramp-up period or a power ramp-down period, as will be described below. In an alternative embodiment, power from the transmitter 200 is supplied to the receiver 170 through a leakage path illustrated using reference numeral 173. The operation of switch 166 is derived from a control signal from baseband subsystem 110 via connection 132.

The power control element 145 operates in an open loop configuration and includes a DAC 142. The DAC 142 supplies a voltage reference signal referred to as V_{APC}. The voltage signal V_{APC} is used to control the power output of the power amplifier and to supply the AM portion of the transmit signal to the power amplifier via a control input on connection 172. The power control element 145 also receives the LO signal from synthesizer 148 via connection 198.

A signal received by antenna 164 may, at the appropriate time determined by control signals from baseband subsystem 110, be directed via switch 166 to the receiver 170, which is tuned to receive the RF signal and directed to a receive filter 168. The receive filter 168 filters the received signal and supplies the filtered signal on connection 174 to a low noise amplifier (LNA) 176. The receive filter 168 may be a bandpass filter that passes all channels of the particular cellular system where the portable transceiver 100 is operating. As an example, for a 900MHz GSM system, receive filter 168 would pass all frequencies from 925.1MHz to 959.9MHz, covering all 174 contiguous channels of 200 kHz each. The purpose of the receive filter 168 is to reject all frequencies outside the desired region. An LNA 176 amplifies the very weak signal on connection 174 to a level at which downconverter 178 can translate the signal from the transmitted frequency back to a baseband frequency. Alternatively, the functionality of the LNA 176 and the downconverter 178 can be accomplished using other elements, such as, for example but not limited to, a low noise block downconverter (LNB).

The downconverter 178 receives an LO signal from synthesizer 148 via connection 180. The LO signal determines the frequency to which to downconvert the signal received from the LNA 176 via connection 182. The downconverted frequency is called the intermediate frequency (IF). In some transceiver embodiments, the received RF signal is downconverted directly to a baseband (0Hz) (referred to as a direct conversion receiver (DCR)) or a near-baseband signal (referred to as a very low intermediate frequency (VLIF)). If implemented as a direct conversion receiver, one or more baseband filters will be substituted for the IF filter 186. The downconverter 178 sends the downconverted signal via connection 184 to a channel filter 186, also called the "IF filter." The channel filter 186 filters the downconverted signal and supplies it via connection 188 to an amplifier 190. The channel filter 186 selects the one desired channel and rejects all others. Using the GSM system as an example, only one of the 174 contiguous channels is actually to be received. After all channels are passed by the receive filter 168 and downconverted in frequency by the downconverter 178, only the one desired channel will appear precisely at the center frequency of channel filter 186. The synthesizer 148, by controlling the local oscillator frequency supplied on connection 180 to downconverter 178, determines the selected channel. The amplifier 190 amplifies the received signal and supplies the amplified signal via connection 192 to demodulator 194. The demodulator 194 recovers the transmitted analog information and supplies a signal representing this information via connection 196 to the ADC 134. The ADC 134 converts these analog signals to a digital signal at baseband frequency and transfers it via bus 128 to DSP 126 for further processing.

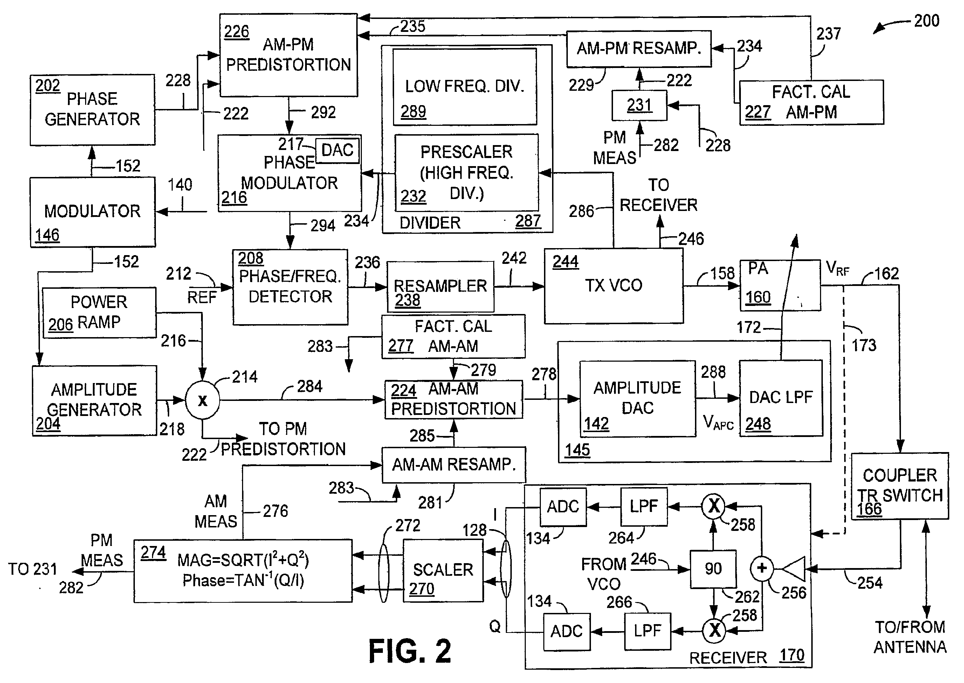

FIG. 2 is a block diagram illustrating a polar loop RF transmitter 200 and a portion of a receiver 170 in accordance with an embodiment of the invention. In the embodiment illustrated in FIG. 2 an I/Q modulator 146 generates a pair of I and Q information signals in either the GSM or the extended data rates for GSM evolution (EDGE) format. One copy of these I and Q information signals is sent via connection 152 to a phase generator 202, which, upon being presented with an I and Q signal pair at its input, will generate the phase of that I and Q signal pair at its output on connection 228. A duplicate copy of the I and Q signal pair from the modulator 146 is sent via connection 152 to an amplitude generator 204. The amplitude generator 204 produces at its output on connection 218 a signal corresponding to the amplitude of the I and Q signal pair at its input on connection 152. The operation of the phase generator 202 and the amplitude generator 204 is well known in the art.

The output of the phase generator 202 is sent to an AM-PM predistortion element 226, which adds a phase offset value to the signal on connection 228 based on the amplitude on connection 222. The AM-PM predistortion is a variable phase term which is a function of the amplitude. Specifically, phase is a non-linear function of amplitude. When using a non-linear power amplifier 160 the phase depends on the output power. The AM-AM and the AM-PM characteristics of the power amplifier are calibrated during manufacturing. The factory-calibrated AM-PM predistortion curves are stored in factory AM-PM element 227. The factory-calibrated AM-PM predistortion curves are provided to the AM-PM predistortion element 226 via connection 237.

In accordance with an embodiment of the invention, the output of the power amplifier is directed to the receiver during either a ramp-up or a ramp-down period of a transmit burst. The receiver is used to determine the power amplifier characteristics and develop real-time estimated of transmitter and power amplifier performance. As will be described below, the transmit characteristics are used to generate updated estimated predistortion curves. The received I and Q samples are used to compute magnitude and phase (φₒᵤₜ). The PM estimated signal, Δ=ϕᵢₙ-ϕₒᵤₜ, is delivered to a phase error estimator 231. The phase error estimator 231 determines a difference in phase between the phase input signal and the phase signal received from the transmitter, through the receiver 170. The phase difference is supplied via connection 222 to an AM-PM resampling element 229. The AM-PM resampling element 229 develops the updated estimated predistortion curves and delivers the estimated predistortion curves to the AM-PM predistortion element 226 via connection 235. The AM-PM predistortion element 226 determines whether to apply the factory-calibrated AM-PM predistortion curves or the updated estimated predistortion curves generated by the AM-PM resampling element 229. The AM-PM predistortion element 226 compares the factory-calibrated AM-PM predistortion curves to the updated estimated AM-PM predistortion curves and determines whether to apply the factory-calibrated AM-PM predistortion curves or the updated estimated AM-PM predistortion curves generated by the AM-PM resampling element 229. For example, if the updated estimated AM-PM predistortion curves generated by the AM-PM resampling element 229 differ from the factory-calibrated AM-PM predistortion curves, then a change in the power amplifier AM-PM characteristic is indicated. Predefined metrics such as the slope of the updated estimated AM-PM curve compared with the factory calibrated curve and the magnitude squared error between the factory calibrated AM-PM curve and the updated estimated curve in the AM-PM predistortion element 226 determine whether the factory calibrated AM-PM curve or the updated estimated AM-PM pre-distortion curve should be applied to the power amplifier.

To minimize the effects of noise on the analysis, a number of measurements are averaged. Application of the updated estimated predistortion curves is based on metrics, such as the metrics described above, that are defined to accept or reject the updated estimated pre-distortion curve. Further, the factory-calibrated predistortion curves are available at all times.

Interpolation order depends on the sample acquisition capability. If the ramp-up signal starts from a predetermined value, pedestal, as opposed to zero, obtaining measurement data for values in the lower part of the pre-distortion curve is not possible. If at the lower part of the power amplifier amplitude and phase curves, sufficient data cannot be obtained to enable estimation of the nonlinearities, using linear interpolation accurately, zero order interpolation can be used to obtain the same values as those obtained during the factory calibration. The reasoning for this decision is that the transmit specification is more tolerant for the transmit output power and shape at lower levels. Another rationalization for this is that the effects of VSWR at the lower parts of the power amplifier curve are less than at the higher powers. However, if the lower part of the power amplifier characteristic can be estimated (with no pedestal) but linear interpolation would not produce good approximation for the nonlinearities, higher order interpolation can be used.

The output of the AM-PM predistortion element 226 is supplied via connection 292 to a phase modulator 216, which includes a phase DAC 217 and which can be implemented as a sigma-delta modulator. Alternatively, the phase can be modulated using a number of different techniques that are known in the art. The AM-PM predistortion element 226 will be discussed in greater detail below. The phase modulator 216 uses the phase input on connection 292 to modulate the phase of an RF signal centered at an RF carrier frequency, which is determined externally to the transmitter 200. The output of the phase modulator 216 is a phase modulated signal and is sent to a phase/frequency detector 208. The phase/frequency detector 208 compares the phase of the signal on connection 294 with a phase reference signal supplied via connection 212. The phase reference signal on connection 212 is supplied by an oscillator (not shown) as known in the art.

The phase/frequency detector 208 detects any phase difference between the signal on connection 294 and the signal on connection 212 and places a signal on connection 236 that has an amplitude proportional to the difference. When the phase difference reaches 360°, the output of phase/frequency detector 208 on connection 236 will become proportional to the frequency difference between the signals on connections 294 and 212.

The output of phase/frequency detector 208 on connection 236 is a digital signal having a value of either a 0 or a 1 with a very small transition time between the two output states. This signal on connection 236 is supplied to resampling element 238, which integrates the signal on connection 236 and places a DC signal on connection 242 that controls the frequency of the transmit voltage control oscillator (TX VCO) 244. The output of TX VCO 244 is supplied via connection 158 directly to the power amplifier 160. The output of the TX VCO 244 is also supplied via connection 286 to a prescaler 232. The prescaler 232 is part of a divider 287 in the PLL. Typically, the divider comprises a high frequency divider (i.e., the prescaler 232), and a lower frequency divider 289.

An RF signal at the signal input 158 of the power amplifier 160 on connection 158 will produce a corresponding RF signal at the output 162 of the power amplifier 160 with an amplitude change corresponding to an amplification factor that is selected for the power amplifier. The amplification factor of the power amplifier is determined by the voltage level at the gain control input 172 of the power amplifier 160.

The output of the amplitude generator 204 on connection 218 is combined with the output of a power ramp element 206 in a multiplier 214. The power ramp element 206 controls the ramp-up and ramp-down portion of the transmit burst, as well as the absolute power level during the burst. This is performed independent of the modulation. The output of the multiplier 214 is passed to the AM-PM predistortion element 226 via connection 222 and to an AM-AM predistortion element 224 via connection 284. The AM-AM predistortion element 224 modifies its input to produce an output which is sent to an amplitude DAC 142. The factory-calibrated AM-AM predistortion curves are stored in factory-calibrated AM-AM element 277. The factory-calibrated AM-AM predistortion curves are provided to the AM-AM predistortion element 224 via connection 279.

In accordance with an embodiment of the invention, the output of the power amplifier is directed to the receiver during either a ramp-up or a ramp-down period of a transmit burst. The receiver is used to determine the power amplifier characteristics and develop real-time estimates of transmitter and power amplifier performance. As will be described below, the transmit characteristics are used to generate updated estimated predistortion curves. The PM estimated signal is delivered to an AM-AM resampling element 281. The AM-AM resampling element 281 develops the updated estimated predistortion curves and delivers the updated estimated predistortion curves to the AM-AM predistortion element 224 via connection 285. The AM-AM predistortion element 224 compares the factory-calibrated AM-AM predistortion curves to the updated estimated AM-AM predistortion curves and determines whether to apply the factory-calibrated AM-AM predistortion curves or the updated estimated AM-AM predistortion curves generated by the AM-AM resampling element 281. For example, if the updated estimated AM-AM predistortion curves generated by the AM-AM resampling element 281 differ from the factory-calibrated AM-AM predistortion curves, then a change in the power amplifier AM-AM characteristic may be indicated based on the predefined metrics such as magnitude squared error between the updated estimated and factory calibrated AM-AM curves in the AM-AM predistortion element 224. This may indicate that the updated estimated AM-AM predistortion curves should be applied to the power amplifier.

The AM-AM predistortion element 224 will be discussed in greater detail below. The amplitude DAC 142 takes a digital input on connection 278 and converts it into an analog voltage at the input to the amplitude DAC LPF (low pass filter) 248 on connection 288. The output of the amplitude DAC LPF 248 is connected to the gain control input of the power amplifier via connection 172. In this embodiment, the amplitude DAC 142 and the DAC LPF 248 constitute the power control element 145 shown in FIG. 1.

When the power amplifier 160 exhibits an ideal linear input-output characteristic the RF signal at the signal input 158 of the power amplifier 160 will be linearly related to the signal at the output of the power amplifier 160 on connection 162 with only a scaling difference between the two. The scaling difference is determined by the amplification factor selected by the signal at the gain control input 172 of the power amplifier 160. In operation, the input-output characteristic of the power amplifier 160 will deviate from being absolutely linear. Characterization of the non-linear nature of a power amplifier can be done in a number of ways. A well known and well understood method to characterize a power amplifier is in terms of its AM-AM and AM-PM distortion characteristics. AM-AM distortion is present when the amplification factor of the power amplifier does not change linearly with changes in the signal at the gain control input 172 of the power amplifier 160. AM-PM distortion is present when there is a phase offset between the RF signal at the signal input 158 of the power amplifier 160 and the RF signal at the output 162 of the power amplifier 160. This phase offset exhibits a dependency on the amplitude of the signal at the gain control input 172 of the power amplifier 160.

The effect of AM-AM and AM-PM distortion is to degrade the spectral characteristics of the RF signal at the output of the power amplifier 160. This degradation can cause a communication system to fail to meet specified performance requirements. In order to ameliorate the impact of AM-AM and AM-PM distortion a well known technique is to apply AM-AM and AM-PM predistortion to the amplitude and phase components as shown in FIG. 2. The AM-AM and AM-PM predistortion characteristics can be determined either by analysis of the signal at the output of the power amplifier when a known signal is applied at the inputs of the power amplifier or by analysis of the design of the power amplifier. The approach in the latter case is inflexible and does not compensate for deviations introduced in the manufacturing process, or transient deviations that occur based on the operating conditions of the power amplifier. The approach in the former case can be implemented using either a dynamic or a static methodology. In the static case the AM-AM and AM-PM characteristics of the power amplifier are determined as part of the manufacturing process and stored as the factory-calibrated AM-AM and AM-PM curves described above, for later use while in the dynamic case the AM-AM and AM-PM characteristics of the power amplifer are continuously updated based on observations of the signal at the output of the power amplifier.

The signal supplied by the amplitude generator 204 represents the desired AM control signal. This signal is provided on connection 284 to the AM-AM predistortion element 224 and on connection 278 to the amplitude DAC 142. The output of the amplitude DAC 142 on connection 288 is the V_{APC} signal and determines the power output of the power amplifier 160.

In accordance with an embodiment of the invention, the output of the power amplifier 160 on connection 162 is supplied to a switch 166, which also functions as a coupler. Illustratively, the switch 166 is a three-way switch that controls whether the amplified signal on connection 162 is transferred to antenna 164, transferred directly from the transmitter output to the receiver input, or whether a received signal from antenna 164 is supplied to filter 168 (FIG. 1) in the receiver 170.

In one embodiment, the switch 166 is positioned so that the output of the transmitter 200 is supplied directly to the receiver 170 so that the transmitter characteristics, and in particular, the AM-AM and AM-PM characteristics, can be analyzed and compensated. The ramp-up and ramp-down periods of the transmit burst are used to analyze the transmit signal in real-time during normal operations of the transceiver. In this manner, the transmit signal is continuously analyzed and updated based on actual operating conditions. This is particularly important during periods of changing VSWR because these changes in VSWR tend to occur for relatively short periods of time and can have significant impact on transmission quality.

To perform transmit signal analysis to determine AM-AM and AM-PM characteristics of the power amplifier, the output of the switch 166 is supplied to the input of the receiver 170 during signal ramp-up and/or during signal ramp-down. A local oscillator signal is taken from the TX VCO 244 and supplied to a phase shift element 262 in the receiver 170 to generate the in-phase (I) and quadrature-phase (Q) components of the RF signal V_{RF} at the output of the power amplifier 160. The phase shifted I and Q signals are processed by low pass filters 264 and 266, and are converted to the digital domain by analog-to-digital converters 134. The downconverted and demodulated baseband (DC) level I and Q information signals are sent via connection 128 to a scaler 270. The scaler 270 normalizes the value of the I and Q information signals and provides them on connection 272 to a magnitude/phase determination element 274. The magnitude/phase determination element 274 determines the magnitude and phase of the baseband I and Q information signals on connection 272. In an embodiment, the scaler 270 and the magnitude/phase determination element 274 are implemented in hardware. However, other implementations are possible. In an embodiment, the magnitude of the I and Q information signals is determined using the formula MAG=SQRT(I²+Q²) and the phase of the I and Q information signals is determined using the formula Phase=TAN⁻¹ (Q/I). However, other computations can be used to determine the power/amplitude and the phase of the I and Q information signals.

The phase information computed by the magnitude/phase determination element 274 is supplied to the phase error estimator 231 and the amplitude information computed by the magnitude/phase determination element 274 is supplied to the AM-AM resampling element 281 via connection 276. The phase error estimator 231 determines a difference in phase between the phase input signal and the phase signal received from the transmitter, through the receiver 170. The phase difference is supplied via connection 222 to the AM-PM resampling element 229. The AM-PM resampling element 229 develops the updated estimated predistortion curves and delivers the estimated predistortion curves to the AM-PM predistortion element 226 via connection 235. The AM-PM predistortion element 226 determines whether to apply the factory-calibrated AM-PM predistortion curves or the updated estimated predistortion curves generated by the AM-PM resampling element 229.

The AM-PM resampling element 229 uses the phase information from the magnitude/phase determination element 274 to develop updated AM-PM compensation curves to adjust the phase of the transmit signal to compensate for real-time non-linearities in the power amplifier caused by AM-PM conversion in the power amplifier. Similarly, the AM-AM resampling element 281 uses the amplitude information from the magnitude/phase determination element 274 to develop updated AM-AM compensation curves to adjust the amplitude of the transmit signal to compensate for real-time non-linearities in the power amplifier caused by AM-AM conversion in the power amplifier.

The output of the magnitude/phase determination element 274 is used to develop compensation tables 360, which can also be referred to as updated calibration or predistortion tables, and which are stored in the memory 122 (FIG. 1). During initialization upon power-up, these tables are transferred to dedicated random access memory (RAM) 199 in the RF/MSD subsystem 130. During normal operation, the predistortion circuits 224 and 226 are operating on the compensation table in the RAM 199.

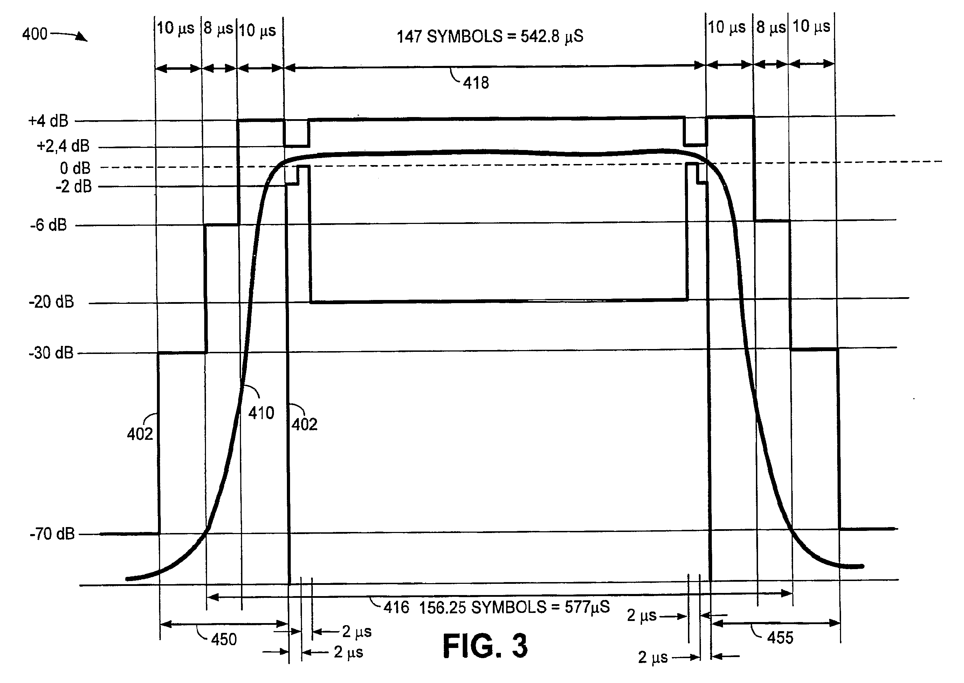

FIG. 3 is a graphical representation of the power output of the power amplifier during a typical EDGE or 8-PSK output burst 400. The curve 410 illustrates a sample power signal output of the power amplifier 180. A power versus time mask 402 defines the power and time parameters within which the curve 410 must remain to comply with regulatory requirements. As shown in FIG. 3, the curve 410 indicates that output power remains below -70 dB until the beginning of the burst 400. In this example, the burst time is 156.25 symbols, which corresponds to 577µs and is indicated using reference numeral 416. The portion of the burst in which data is transmitted is 147 symbols in duration, which corresponds to 542.8µs, and is indicated using reference numeral 418. The ramp up of the curve 410 occurs in the 28µs preceding the beginning of the period 418 and is indicated using reference numeral 450. The ramp down of the curve 410 occurs in the 28µs after the period 418 and is indicated using reference numeral 455.

Either the ramp-up period 450 or the ramp-down period 455 can be used to direct the output of the power amplifier 160 to the receiver 170 to generate real-time transmit power amplifier characteristics to determine whether to adaptively update the AM-AM and the AM-PM predistortion curves applied to the power amplifier. In an embodiment, the ramp-down period 455 allows the opportunity to estimate any DC components in the receive path prior to calibration. In this manner, the transmitter operates in a quasi closed-loop manner for a short period of time during some transmit bursts. This minimizes power consumption and takes advantage of the receiver components that are available and not being used for meaningful data reception during the ramp-up and the ramp-down portions of the transmit burst. At the end of a call the AM-AM and AM-PM predistortion curves revert back to the factory calibrated curves. During a single call an average of the estimates over N transmit bursts are used where N is programmable. Also for a multislot case, it would be a programmable parameter to obtain estimates from just the first, the last, or a combination of transmit bursts. The above-described pre-distortion estimation is done on every transmit burst. The resulting updated estimated curves are averaged over a number of bursts. The decision to apply the updated estimated predistortion curves depends on an error criteria which determines the validity of the estimation process. The metric could be based on the error between the updated estimated predistortion curve and the factory calibrated predistortion curve, or the slope of the deviation of the updated estimated predistortion curve from the factory calibrated predistortion curve. Other metrics may also be used as known in the art.

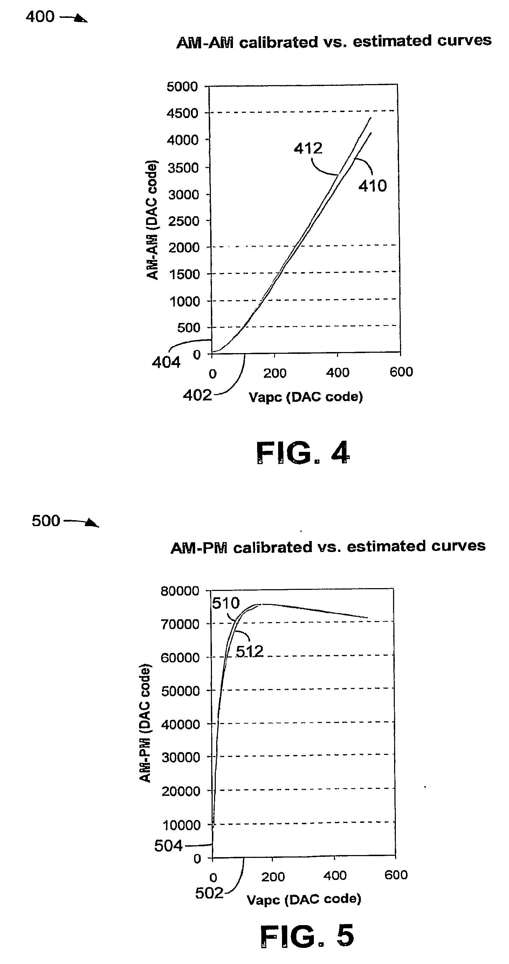

FIG. 4 is a graphical illustration 400 showing an example of AM-AM power amplifier distortion curves showing a factory calibration curve and an estimated curve obtained as described above. The horizontal axis 402 represents the power control signal, V_{APC}, and the vertical axis 404 represents 1/V_{RF} (DAC 142 value), where V_{RF} is the output power of the power amplifier. The curve 410 represents the factory calibrated AM-AM predistortion curve and the curve 412 represents an updated estimated AM-AM predistortion curve. The difference between the factory calibrated AM-AM predistortion curve 410 and the updated estimated AM-AM predistortion curve 412 is generally a difference in slope of the two curves as a result of changing voltage standing wave ratio (VSWR), but can result from other factors.

FIG. 5 is a graphical illustration 500 showing an example of an AM-PM power amplifier distortion curves showing a factory calibration curve and an estimated curve obtained as described above. The horizontal axis 502 represents the power control signal, V_{APC}, and the vertical axis 504 represents phase (DAC 142 value). The curve 510 represents the factory calibrated AM-PM predistortion curve and the curve 512 represents an updated estimated AM-PM predistortion curve. The difference between the factory calibrated AM-PM predistortion curve 510 and the updated estimated AM-PM predistortion curve 512 is generally a difference in slope of the two curves as a result of changing voltage standing wave ratio (VSWR), but can result from other factors.

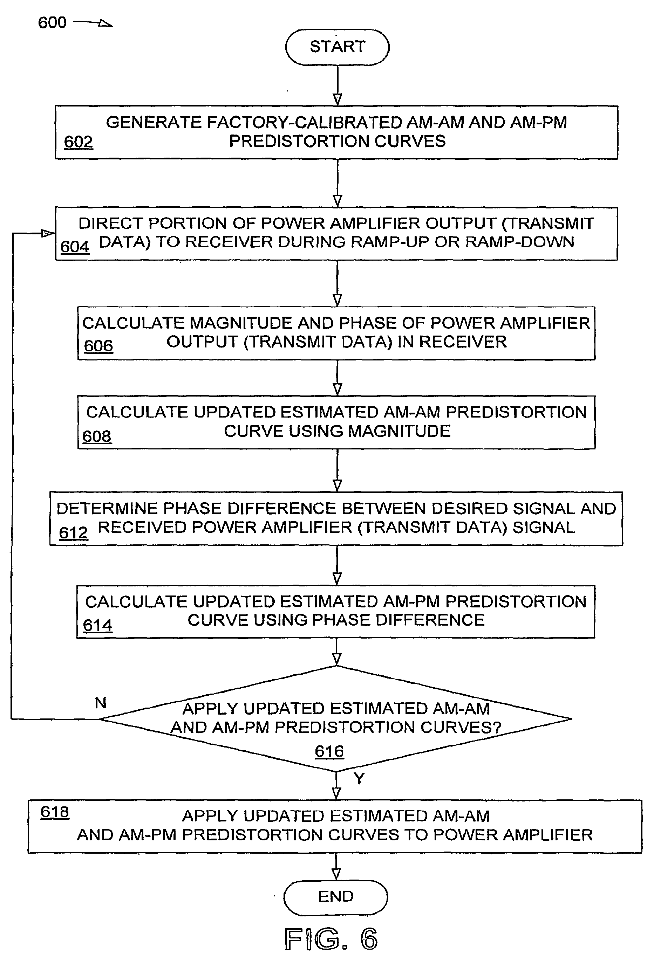

FIG. 6 is a flow chart 600 describing the operation of an embodiment of the invention. The blocks in the flow chart 600 illustrate one possible manner of implementing the adaptive predistortion system and method for controlling an open loop power amplifier and can be executed in the order shown, out of the order shown or substantially in parallel. In block 602, the factory-calibrated AM-AM and AM-PM predistortion curves are generated. In block 604, a portion of the output of the power amplifier 160 is directed to the receiver 170 during a ramp-up or a ramp-down period of a transmit burst. In block 606, the magnitude and phase of the transmit signal is calculated using the receiver 170. In block 608, an updated estimated AM-AM predistortion curve is calculated by the AM-AM resampling element 281 using the magnitude calculated in block 606.

In block 612, a phase difference between the phase input signal and the phase signal received from the transmitter, through the receiver 170, is determined by the phase error estimator 231. In block 614, the AM-PM resampling element 229 develops an updated estimated AM-PM predistortion curve. In block 616, it is determined whether to apply the updated estimated AM-AM and AM-PM predistortion curves to the power amplifier. The AM-AM predistortion element 224 compares the factory- calibrated AM-AM predistortion curve to the updated estimated AM-AM predistortion curve. Similarly, the AM-PM predistortion element 226 compares the factory-calibrated AM-PM predistortion curve to the updated estimated AM-PM predistortion curve.

If the updated estimated AM-AM and AM-PM predistortion curves differ from the factory-calibrated AM-AM and AM-PM predistortion curves, respectively, then, in block 618, the updated estimated AM-AM and AM-PM predistortion curves are applied to the power amplifier if the updated estimated predistortion curves are qualified by the above-mentioned metrics. If the updated estimated AM-AM and AM-PM predistortion curves do not differ from the factory-calibrated AM-AM and AM-PM predistortion curves, then the process returns to block 604.

## Claims

1. An adaptive predistortion system for controlling an open loop power amplifier, comprising:
a transmitter (200);
a receiver (170);
a phase and amplitude determination element (202, 204) configured to determine amplitude and phase characteristics of an output signal generated in the transmitter, the signal representing transmitter characteristics;
an amplitude resampling element (281) configured to generate an updated AM-AM predistortion signal based on the output signal generated in the transmitter;
an amplitude predistortion element (224) configured to compare the updated AM-AM predistortion signal with a factory-calibrated AM-AM predistortion signal and generate an amplitude compensation signal;
a phase comparison element (231) configured to compare the signal representing transmitter characteristics with a desired phase signal;
a phase resampling element (229) configured to generate an updated AM-PM predistortion signal based on the output signal generated in the transmitter; and
a phase predistortion element (226) configured to compare the updated AM-PM predistortion signal with a factory-calibrated AM-PM predistortion signal and generate a phase compensation signal.

2. The system of claim 1 wherein the output signal is analyzed during a period of the transmit burst chosen from a ramp-up period and a ramp-down period.

3. The system of claim 1 wherein the amplitude and phase characteristics are used to develop an updated estimated AM-PM characteristic curve and an updated estimated AM-AM characteristic curve for the power amplifier.

4. The system of claim 1 wherein the amplitude compensation signal and the phase compensation signal are applied to the transmitted signal.

5. The system of claim 1 wherein an output of the transmitter is provided to the receiver via a leakage path or via a coupler configured to couple a portion of the output signal of the transmitter to the receiver.

6. The system of claim 1 wherein the output signal generated in the transmitter is a data signal.

7. The system of claim 1 wherein AM-AM and AM-PM conversion in a power amplifier associated with the transmitter are simultaneously adaptively compensated.

8. The system of claim 1 in which the open loop power amplifier is for a portable receiver and the transmitter includes a power amplifier.

9. A method for adaptively controlling an open loop power amplifier, comprising:
providing an output signal;
routing the output signal to a receiver (170);
determining amplitude and phase characteristics of the output signal (at 202, 204), the output signal representing transmitter characteristics;
generating an updated AM-AM predistortion signal (at 281) based on the output signal generated in the transmitter;
comparing the updated AM-AM predistortion signal (at 224) with a factory-calibrated AM-AM predistortion signal and generating an amplitude compensation signal;
comparing the signal (at 231) representing transmitter characteristics with a desired phase signal;
generating an updated AM-PM predistortion signal (at 229) based on the output signal generated in the transmitter; and
comparing the updated AM-PM predistortion signal (at 226) with a factory-calibrated AM-PM predistortion signal and generating a phase compensation signal.

10. The method of claim 9 further comprising analyzing the output signal during a period of a transmit burst chosen from a ramp-up period and a ramp-down period.

11. The method of claim 10 further comprising using the amplitude and phase characteristics to develop an updated estimated AM-PM characteristic curve and an updated estimated AM-AM characteristic curve for the power amplifier.

12. The method of claim 9 further comprising applying the amplitude compensation signal and the phase compensation signal to the transmitted signal.

13. The method of claim 9 further comprising providing the output signal to the receiver via a leakage path or coupling a portion of the output signal to the receiver.

14. The method of claim 9 wherein the output signal generated in the transmitter is a data signal.

15. The method of claim 9 further comprising simultaneously compensating AM-AM and AM-PM conversion in a power amplifier associated with the transmitter.

## Patentansprüche

1. Adaptives Vorverzerrungssystem zum Steuern eines Open-Loop-Leistungsverstärkers, das Folgendes umfasst:
einen Sender (200);
einen Empfänger (170);
ein Phasen- und Amplitudenfeststellungselement (202, 204), konfiguriert zum Feststellen von Amplituden- und Phasenkennwerten eines im Sender erzeugten Ausgangssignals, wobei das Signal Senderkennwerte repräsentiert;
ein Amplitudenneuabtastelement (281), konfiguriert zum Erzeugen eines aktualisierten AM-AM-Vorverzerrungssignals auf der Basis des im Sender erzeugten Ausgangssignals;
ein Amplitudenvorverzerrungselement (224), konfiguriert zum Vergleichen des aktualisieren AM-AM-Vorverzerrungssignals mit einem werkskalibrierten AM-AM-Vorverzerrungssignal und zum Erzeugen eines Amplitudenkompensationssignals;
ein Phasenvergleichselement (231), konfiguriert zum Vergleichen des Senderkennwerte repräsentierenden Signals mit einem gewünschten Phasensignal;
ein Phasenneuabtastelement (229), konfiguriert zum Erzeugen eines aktualisierten AM-PM-Vorverzerrungssignals auf der Basis des im Sender erzeugten Ausgangssignals; und
ein Phasenvorverzerrungselement (226), konfiguriert zum Vergleichen des aktualisierten AM-PM-Vorverzerrungssignals mit einem werkskalibrierten AM-PM-Vorverzerrungssignal und zum Erzeugen eines Phasenkompensationssignals.

2. System nach Anspruch 1, wobei das Ausgangssignal während einer Periode des aus einer Hochfahrperiode und einer Herunterfahrperiode gewählten Sende-Burst analysiert wird.

3. System nach Anspruch 1, wobei die Amplituden- und Phasenkennwerte zum Entwickeln einer aktualisierten geschätzten AM-PM-Kennlinie und einer aktualisierten geschätzten AM-AM-Kennlinie für den Leistungsverstärker benutzt werden.

4. System nach Anspruch 1, wobei das Amplitudenkompensationssignal und das Phasenkompensationssignal auf das gesendete Signal angewendet werden.

5. System nach Anspruch 1, wobei ein Ausgang des Senders an den Empfänger über einen Leckpfad oder über einen Koppler angelegt wird, der zum Koppeln eines Teils des Ausgangssignals des Senders mit dem Empfänger konfiguriert ist.

6. System nach Anspruch 1, wobei das im Sender erzeugte Ausgangssignal ein Datensignal ist.

7. System nach Anspruch 1, wobei AM-AM- und AM-PM-Konversion in einem mit dem Sender assoziierten Leistungsverstärker gleichzeitig adaptiv kompensiert werden.

8. System nach Anspruch 1, wobei der Open-Loop-Leistungsverstärker für einen tragbaren Empfänger ist und der Sender einen Leistungsverstärker beinhaltet.

9. Verfahren zum adaptiven Steuern eines Open-Loop-Leistungsverstärkers, das Folgendes beinhaltet:
Bereitstellen eines Ausgangssignals;
Leiten des Ausgangssignals zu einem Empfänger (170);
Ermitteln von Amplituden- und Phasenkennwerten des Ausgangssignals (bei 202, 204), wobei das Ausgangssignal Senderkennwerte repräsentiert;
Erzeugen eines aktualisierten AM-AM-Vorverzerrungssignals (bei 281) auf der Basis des im Sender erzeugten Ausgangssignals;
Vergleichen des aktualisierten AM-AM-Vorverzerrungssignals (bei 224) mit einem werkskalibrierten AM-AM-Vorverzerrungssignal und Erzeugen eines Amplitudenkompensationssignals;
Vergleichen des Senderkennwerte repräsentierenden Signals (bei 231) mit einem gewünschten Phasensignal;
Erzeugen eines aktualisierten AM-PM-Vorverzerrungssignals (bei 229) auf der Basis des im Sender erzeugten Ausgangssignals; und
Vergleichen des aktualisierten AM-PM-Vorverzerrungssignals (bei 226) mit einem werkskalibrierten AM-PM-Vorverzerrungssignal und Erzeugen eines Phasenkompensationssignals.

10. Verfahren nach Anspruch 9, das ferner das Analysieren des Ausgangssignals während einer Periode eines aus einer Hochfahrperiode und einer Herunterfahrperiode gewählten Sende-Bursts beinhaltet.

11. Verfahren nach Anspruch 10, das ferner die Nutzung der Amplituden- und Phasenkennwerten zum Entwickeln einer aktualisierten geschätzten AM-PM-Kennlinie und einer aktualisierten geschätzten AM-AM-Kennlinie für den Leistungsverstärker beinhaltet.

12. Verfahren nach Anspruch 9, das ferner das Anwenden des Amplitudenkompensationssignals und des Phasenkompensationssignals auf das gesendete Signal beinhaltet.

13. Verfahren nach Anspruch 9, das ferner das Senden des Ausgangssignals zu dem Empfänger über einen Leckpfad oder das Koppeln eines Teils des Ausgangssignals mit dem Empfänger beinhaltet.

14. Verfahren nach Anspruch 9, wobei das im Sender erzeugte Ausgangssignal ein Datensignal ist.

15. Verfahren nach Anspruch 9, das ferner das gleichzeitige Kompensieren von AM-AM- und AM-PM-Konversion in einem mit dem Sender assoziierten Leistungsverstärker beinhaltet.

## Revendications

1. Système de prédistorsion adaptative destiné à la commande d'un amplificateur de puissance en boucle ouverte, comprenant :
un émetteur (200) ;
un récepteur (170) ;
un élément de détermination de phase et d'amplitude (202, 204) configuré pour déterminer des caractéristiques d'amplitude et de phase d'un signal de sortie généré dans l'émetteur, le signal représentant des caractéristiques de l'émetteur ;
un élément de rééchantillonnage d'amplitude (281) configuré pour générer un signal de prédistorsion MA-MA actualisé en fonction du signal de sortie généré dans l'émetteur ;
un élément de prédistorsion d'amplitude (224) configuré pour comparer le signal de prédistorsion MA-MA actualisé à un signal de prédistorsion MA-MA calibré en usine et générer un signal de compensation d'amplitude ;
un élément de comparaison de phase (231) configuré pour comparer le signal représentant des caractéristiques de l'émetteur à un signal de phase souhaité ;
un élément de rééchantillonnage de phase (229) configuré pour générer un signal de prédistorsion MA-MP actualisé en fonction du signal de sortie généré dans l'émetteur ; et
un élément de prédistorsion de phase (226) configurés pour comparer le signal de prédistorsion MA-MP actualisé à un signal de prédistorsion MA-MP calibré en usine et générer un signal de compensation de phase.

2. Système selon la revendication 1 dans lequel le signal de sortie est analysé durant une période de la salve émise choisie dans une période d'accélération et une période de décélération.

3. Système selon la revendication 1 dans lequel les caractéristiques d'amplitude et de phase sont utilisées pour développer une courbe caractéristique MA-MP estimée actualisée et une courbe caractéristique MA-MA estimée actualisée pour l'amplificateur de puissance.

4. Système selon la revendication 1 dans lequel le signal de compensation d'amplitude et le signal de compensation de phase sont appliqués au signal émis.

5. Système selon la revendication 1 dans lequel une sortie de l'émetteur est fournie au récepteur par l'intermédiaire d'un chemin de fuite ou par l'intermédiaire d'un coupleur configuré pour coupler une partie du signal de sortie de l'émetteur au récepteur.

6. Système selon la revendication 1 dans lequel le signal de sortie généré dans l'émetteur est un signal de données.

7. Système selon la revendication 1 dans lequel les conversions MA-MA et MA-MP dans un amplificateur de puissance associé à l'émetteur sont compensées de manière adaptative simultanément.

8. Système selon la revendication 1 dans lequel l'amplificateur de puissance en boucle ouverte est destiné à un récepteur portable et l'émetteur comporte un amplificateur de puissance.

9. Procédé de commande adaptative d'un amplificateur de puissance en boucle ouverte, comprenant :
la fourniture d'un signal de sortie ;
le routage du signal de sortie jusqu'à un récepteur (170) ;
la détermination de caractéristiques d'amplitude et de phase du signal de sortie (en 202, 204), le signal de sortie représentant des caractéristiques de l'émetteur ;
la génération d'un signal de prédistorsion MA-MA actualisé (en 281) en fonction du signal de sortie généré dans l'émetteur ;
la comparaison du signal de prédistorsion MA-MA actualisé (en 224) à un signal de prédistorsion MA-MA calibré en usine et la génération d'un signal de compensation d'amplitude ;
la comparaison du signal (en 231) représentant des caractéristiques de l'émetteur à un signal de phase souhaité ;
la génération d'un signal de prédistorsion MA-MP actualisé (en 229) en fonction du signal de sortie généré dans l'émetteur ; et
la comparaison du signal de prédistorsion MA-MP actualisé (en 226) à un signal de prédistorsion MA-MP calibré en usine et la génération d'un signal de compensation de phase.

10. Procédé selon la revendication 9 comprenant en outre l'analyse du signal de sortie durant une période de la salve émise choisie dans une période d'accélération et une période de décélération.

11. Procédé selon la revendication 10 comprenant en outre l'utilisation des caractéristiques d'amplitude et de phase pour développer une courbe caractéristique MA-MP estimée actualisée et une courbe caractéristique MA-MA estimée actualisée pour l'amplificateur de puissance.

12. Procédé selon la revendication 9 comprenant en outre l'application du signal de compensation d'amplitude et du signal de compensation de phase au signal émis.

13. Procédé selon la revendication 9 comprenant en outre la fourniture d'une sortie de l'émetteur au récepteur par l'intermédiaire d'un chemin de fuite ou le couplage d'une une partie du signal de sortie au récepteur.

14. Procédé selon la revendication 9 dans lequel le signal de sortie généré dans l'émetteur est un signal de données.

15. Procédé selon la revendication 9 comprenant en outre la compensation simultanée des conversions MA-MA et MA-MP dans un amplificateur de puissance associé à l'émetteur.
